Europäisches Patentamt

European Patent Office

Office européen des brevets

(11) Publication number: **0 567 716 A1**

# EUROPEAN PATENT APPLICATION

(21) Application number: **92830201.7**

(22) Date of filing: **30.04.92**

(51) Int. Cl.5: **H03K 3/356**

(43) Date of publication of application:
**03.11.93 Bulletin 93/44**

(84) Designated Contracting States:
**CH DE FR GB IT LI**

(71) Applicant: **SGS-THOMSON MICROELECTRONICS S.p.A.**
**Via C. Olivetti, 2**
**I-20041 Agrate Brianza (MI)(IT)**

(72) Inventor: **Fucili, Giona**

Via Vigna, 4
I-61016 Pennabilli(IT)
Inventor: **Gola, Alberto**
**Via Eseguiti, 22bis**
**I-27043 Broni(IT)**

(74) Representative: **Pellegri, Alberto et al**
**c/o Società Italiana Brevetti S.p.A.**
**Via Puccini, 7**
**I-21100 Varese (IT)**

(54) **Static edgetriggered D flip-flop with a low power consumption.**

(57) A static, edgetriggered, D flip-flop has the second (feedback) inverter of each latch of the flip-flop structure formed by four field effect, complementary-by-pair, transistors (MP1, MN1, MP2, MN2), functionally connected in series between the supply nodes. A first pair of complementary transistors (MP2, MN2) having a source connected to one and the other supply nodes, respectively, have a gate which is connected to the supply node of opposite sign as referred to the sign of the supply node to which the respective source is connected. The other pair of complementary transistors (MP1,MN1) Have their drain connected in common to the output node (A) of the inverter, a gate connected to the output node of the first (forward) inverter (I) of the latch, and a size which is essentially smaller than the size of said first pair of complementary transistors (MP2, MN2).

fig. 11

*FIELD OF THE INVENTION*

The present invention relates to CMOS logic circuits and particularly to static flip-flops of the master-slave type, having a low power consumption.

*BACKGROUND OF THE INVENTION*

Flip-flops (FF) are extensively used in counters. Commonly, D type flip-flops (D-FF) are particularly useful in non-ripple type counters, i.e. in counters wherein a clock signal arrives simultaneously to all the FF which make up a counter, notwithstanding the fact that the may also be used for making ripple-type counters. The power consumption of these counters is a function of two factors. A first factor is tied to the number of switchings while the other factor is tied to the load capacitance which needs to be charged and discharged by the clock signal for each cycle. If the counter is composed of an n number of FF and is made to count up to $2^n-1$, it is possible to demonstrate that generally there will be a number N, depending on the type of circuit used for making the FF and the technology used for fabricating the device, for which if $n>N$ the second contribution to power consumption becomes prevaling in respect to the first contribution (N may also be equal to zero in some instances).

In order to reduce power consumption of multibit counters or more generally of FF undergoing relatively unfrequent switchings, a reduction of the capacitive load on the clock remains important, but at the same time it is advantageous to make FF which have a low consumption during switchings.

Commonly, the clock signal does not drive the FF directly, but these are driven by signals which are derived therefrom, often called clock phases f and f', which are derived by the clock signal by means of suitable circuits (commonly referred to by the name of "clock drivers").

From a logic point of view, the clock phases (f, f') or simply the two clock signals, are such that $f=$ clock and $f'=$ NOTclock. If each signal drives a load C, this will produce an average current comsumption equal to: $I = (C^*Vdd)/(T/2)$, where T is the clock period and Vdd is the supply voltage.

In turn, also the clock driver circuit will have an intrinsic power consumption which, for the same dynamical performance, is practically proportional to the driven load.

In conclusion, by decreasing by a certain factor the capacitive load borne by the clock phases f and f', a proportional reduction of the consumption of the whole counter-plus-driver system is obtained, less a constant term which depends from the number of switchings. This latter constant term is intimately tied to the structure used for the FF and represents the sum of two contributions:

a) during a transition there is a direct current flow from the supply rail and ground because the voltage at the input of inverters or of other CMOS logic gates, is such as to make both the complementary MOS transistors of the CMOS structure conducting for a certain interval of time;

b) the voltages on the output nodes of the logic gates vary from 0 to Vdd and viceversa and as a consequence the input capacitances of the logic gates which are connected to said output nodes must be charged or discharged. This second contribution is generally dominating as compared with the first contribution.

From what has been said hereinabove, it is clear that in order to reduce power consumption, an FF must be made with a minimum number of MOS transistors and these must be as small as possible. In particular, in a counter there must be the smallest number of transistors driven by the clock signals f and f' as possible.

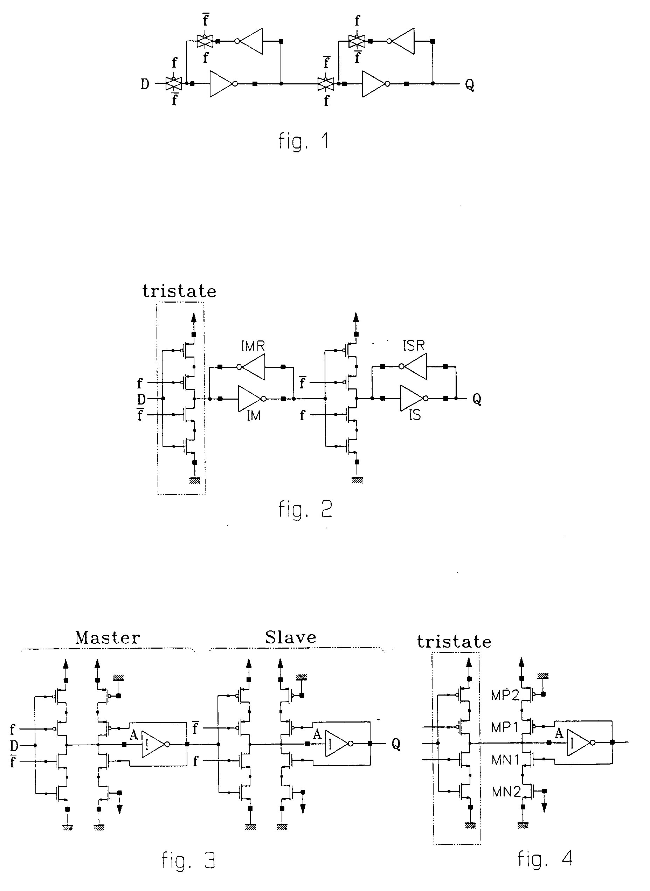

In literature, many types of FF made with eight, four or even with only two MOS transistors driven by the clock phases are described. However, for various reasons, they do not satisfy the specific requisites for their use in a counter. For example they are not static and/or cannot operate at relatively low supply voltages. On the other hand, among known static FF of the master-slave type, i.e. made by two latch-type FF (that is by two level-sensitive FF), connected in cascade and enabled by opposite clock signals as shown in Fig. 1, there is a type which has been developed and used exclusively for obviating to metastability problems and which is characterized by possessing a hysteresis. Such a hysteresis flip-flop has only four MOS transistors driven by the clock signals as compared with the eight transistors of the more classic master-slave structure of a static FF, as schematically depicted in Fig. 1.

Such a known hysteresis FF, depicted in Fig. 2, has a rather high consumption during switchings and is relatively slow (it may be recalled here that, in a counter, the first FF switches every clock cycle!). In fact, the inverters IMR and ISR which close the rings IM-IMR and IS-ISR, respectively, (Fig. 2), must be made with MOS having a relatively long channel in order that the tristate input gates of the two latches may force the output of the respective feedback inverter, (the loop-closing inverter) IMR and ISR, to the appropriate logic value. On the other hand, the need to make the second inverters IMR and ISR with MOS transistors having a relatively long channel implies a large capacitive load on the inputs of the same inverters and this causes a high power consumption during the switchings.

## OBJECTIVE AND SUMMARY OF THE INVENTION

A main objective of the present invention is to provide an improved Master-Slave type, static flip-flop (FF), having a relatively low consumption especially during nonswitching cycles and which is capable of functioning also with a relatively low supply voltage.

This objective is fully accomplished, thus overcoming the limitation of the known structures, by making the feedback inverters of the loops of the two latch circuits, i.e. of the master latch and of the slave latch which compose the basic FF structure, with four field effect transistors, complementary-by-pair among each other of which the two transistors having a source terminal directly connected to either one of the supply nodes have a sufficiently large size in order that the input tristate gate of each latch may adequately force the appropriate logic value onto the output node of the inverter, i.e. on the input node of the latch, while the other two transistors, having their respective drains connected in common to the output node of the inverter, have essentially a smaller size than said first pair of complementary transistors and may advantageously have the minimum size which is permitted by the particular fabrication technology of the integrated device and are driven through a gate terminal by the first inverter of the latch.

## BRIEF DESCRIPTION OF THE DRAWINGS

**Figure 1** is the functional block diagram of a classic, static, D-FF.

**Figure 2** is the functional diagram of a hysteresis type, static, D-FF, according to the prior art.

**Figure 3** represents the circuit of a low consumption, static, D-FF, made in accordance with the present invention.

**Figure 4** shows the structure of a single latch forming the D-FF of Fig. 3.

**Figure 5** shows the complete circuit of a low consumption static D-FF, made in accordance with the present invention.

**Figure 6** shows the complete circuit of a hysteresis type static D-FF according to the prior art.

**Figures 7 and 8** are portions of a circuit of the invention showing the mechanisms for forcing a certain logic level on the input node of each latch circuit through an input tristate gate.

**Figures 9 and 10** are diagrams showing the voltage of the input node of the first inverter of the latches, while raising toward a high logic state and dropping toward low logic state, respectively.

**Figure 11** shows a circuit similar to the one depicted in Fig. 4, wherein respective sizes of MOS transistors which form the second feedback inverter of the latches are shown.

The circuits shown in the figures have an exclusively illustrative and nonlimitative purpose. For sake of simplicity, all the figures relate to the realization of a D-type static flip-flop, i.e. having a single preset input, made in accordance with the invention. Of course, as it is well known to any person skilled in this particular field, it is possible to realize a JK-type flip-flop, i.e. having a set and a reset input or also a T-type flip-flop, having no set or reset inputs, by utilizing the basic structure of a D-type flip-flop and simply "adding" the appropriate input logic circuitry.

## DESCRIPTION OF PREFERRED EMBODIMENTS

With reference to **Figures 3** and **4**, the **FF** of the invention is of the so-called master-slave type and is formed by two substantially identical latch circuits; namely: a master latch and a slave latch, respectively. One of the two latches is shown singularly in **Fig. 4**. The two latches are driven by a pair of phase-opposed clock signals: **f** and **f'** (or **Nf** or **NOT(f)**), which drive complementary type **MOS** transistors, respectively, of both latches forming the **FF**.

In a so-called edge triggered drive configuration of the circuits shown in the figures, the **p**-channel **MOS** transistors which in the master latch are driven by **f**, in the slave latch are driven by **f'** and viceversa for the n-channel **MOS** transistors, thus implementing a so-called positive-edge trigger **FF**. By inverting the clock signals a negative-edge trigger **FF** is obtained.

When **f=0**, the master latch reads an input datum. When **f→1**, the input node is decoupled from the external word because the tristate input gate takes a high impedance state and the datum is maintained during the **f=1** phase because a closed loop exists between ouput node and input node and which is implemented by means of the second, four-**MOS**, "feedback" inverter of the latch. Similarly, when **f=1**, the slave latch reads an input datum and thereafter maintains it during the **f=0** phase. In such a drive configuration, the **FF** reproduces the input datum on the positive front of the clock signals (positive edge trigger).

The drains of transistors **MP2** and **MN2** of the four-transistor "feedback" inverter of each latch of the **FF** (**Fig. 4**) undergo a certain voltage excursion at every transition because the gate of **MP2** is connected to ground and the gate of **MN2** is connected to **Vdd** and therefore, there will be a charging and a discharging of capacitances upon every transition. However, contrary to what happens in a hysteresis type **FF** of the prior art, as depicted in **Fig. 2**, for the same sizes of transistors, the electrical charges which are involved during transitions are positively and significantly less in the case of the structure of the invention, for the following reasons:

1) In the **MOS** transistors of the feedback inverters **IMR** and **ISR** of a static, hysteresis type, **D-FF**, of the prior art (**Fig. 2**), both the gate voltage as well as the drain voltage vary, while in the **MP2** and **MN2 MOS** transistors of the structure of the invention (**Fig. 4**), only the drain voltage is subject to variations, as already pointed out before. Notwithstanding the fact that the power consumption associated with the excursions of the drain voltage of transistors **MP2** and **MN2** must be added the consumption due to the voltage variations across the terminals of the **MP1** and **MN2** transistors, these consumptions are relatively small because the latter transistors in the circuit of the present invention may have advantageously the minimum size, as permitted by the fabrication process.

2) In a circuit of the prior art (**Fig. 2**), the voltage excursions on the gate of the **MOS** transistors of the feedback inverters **IMR** and **ISR**, have an amplitude equal to the supply voltage, by contrast, the drains of transistors **MP2** and **MN2** of the equivalent inverters, in the circuit of the invention (**Fig. 4**), have a voltage swing which is about equal to **Vdd-Vs**, where **Vs** is the threshold of the first inverter **I**. In fact, by supposing that the logic value stored on the output node of the inverter **I** (**Fig. 4**) be zero, on the input (node **A**) of the same inverter **I** and therefore on the output node (node **Ā**) of the second four-**MOS** feedback inverter, there will be a logic state **1**, i.e. a voltage equal to **Vdd**. Moreover, by supposing that the datum present on the input node of the input tristate gate (which is an inverting gate) be equal to **1**, when the tristate gate becomes conducting, it will force the output of the four-**MOS** feedback inverter (node **Ā**) to a logic **0** state. Therefore the voltage on the input node (node **A**) of the first inverter **I**, by passing from **Vdd** to **0V**, will cross the inversion threshold **Vs**. At that moment, the output of the first inverter **I** will switch from **0** to **Vdd** (obviously with a certain delay) and there-fore **MP1** will stop conducting while **MN1** will start conducting. Therefore, the drain of **MP2** will never reach the ground voltage (**0V**) and during the opposite transition, the drain of **MN2** will never reach the supply voltage (**Vdd**). Indeed, a more precise calculation should also consider the drain-source voltage drops across transistors **MP1** and **MN1**, however these transistors have a relatively small size and therefore these voltage drops are relatively small and quite negligeable. What is important instead, because it brings to an increase of the drain voltage swings of **MP2** and **MN2**, is the delay intercurring between the passage of the input (node **A**) of the first inverter **I** through the threshold value **Vs** and the consequent switching of the output node. However, as it will be evident, such a delay is minimized because the inverter **I** drives exclusively **MOS** transistors having a minimum size (**MP1** and **MN1**).

Therefore, beside a low power consumption, the **FF** made in accordance with the invention is also relatively fast, by virtue of the relatively small intrinsic load which the first inverter **I** of each latch circuit forming the **FF**, must drive. The fact that the circuit possesses hysteresis represents a further intrinsic advantage which adds to the advantages mentioned above because the circuit exhibits an enhanced noise rejection ability.

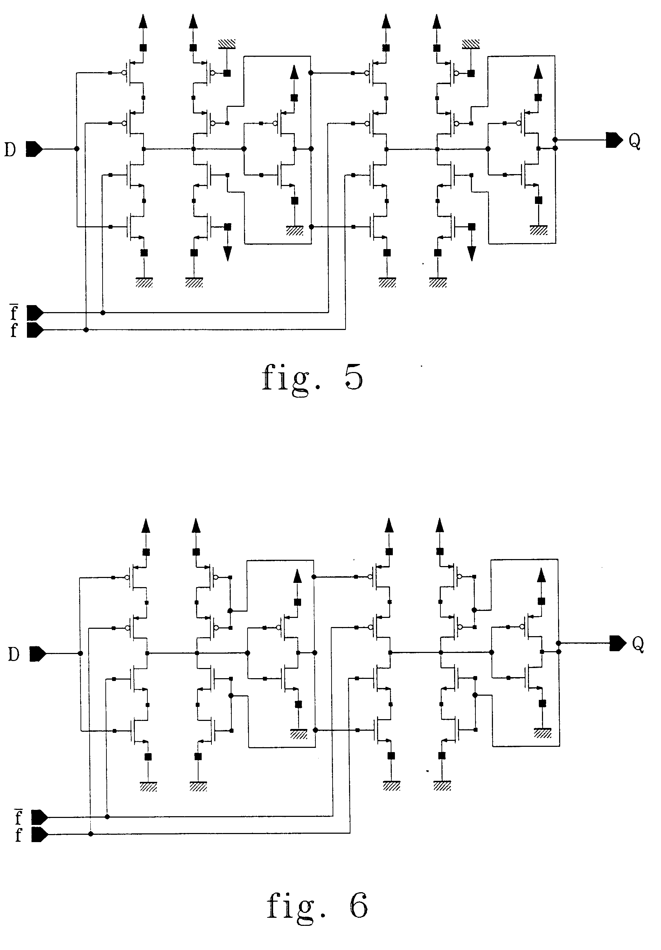

A preferred embodiment of a **D**-type, flip-flop having a low consumption, made in accordance with the present invention, is depicted in more detail in **Fig. 5**. For facilitating an immediate comparison, a complete circuit of a **D**-type, hysteresis flip-flop made according to the prior art is depicted in **Fig. 6**.

*DIMENSIONING OF THE PULL–UPs AND OF THE PULL–DOWNs IN A LOW CONSUMPTION FF OF THE INVENTION*

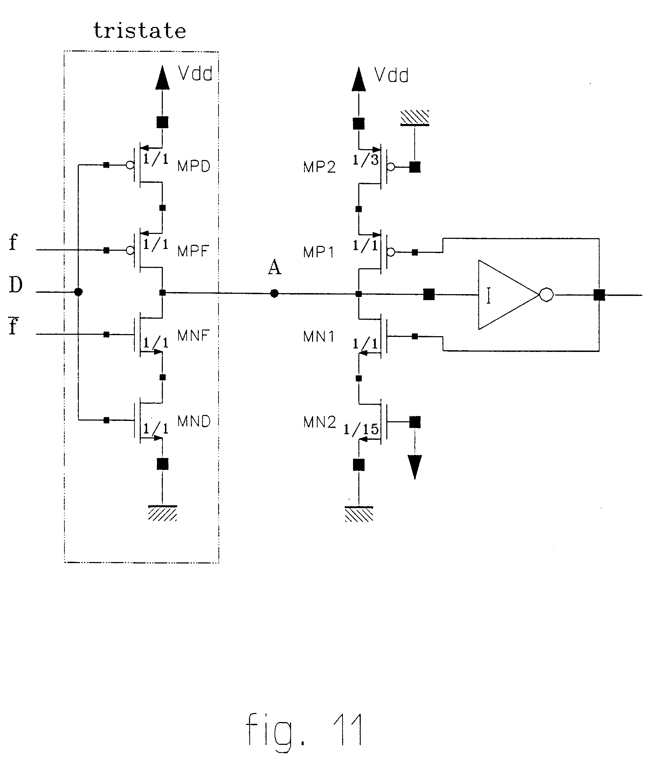

In a low power consumption **FF**, as depicted in **Figures 3** and **4**, in order to store a datum it is necessary to force a voltage on the node **A** such as to overcome the threshold voltage **Vs** of the inverter **I**. By supposing for example that on the output of the latch whose functional structure is reproduced again in **Fig. 11**, a "logic **1**" be stored, on the node **A** there will be a logic "**0**". If **D=0**, when the input tristate gate becomes conducting (i.e. for **f→1**), such a stored datum must be transferred to the output and therefore on the node **A** there will be a logic "**1**". This may only happen if $V_A$ is forced from zero to **Vs+r** (where **r>0**), because in such a case the pull-down transistor **MN2** is disconnected as a consequence of the switching off of the transistor **MN1**, caused by the switching of the inverter.

A logic **"1"** is stored through an identical mechanism, with the only variation that in such a case, the $V_A$ must be forced from **Vdd** to **Vs-r** (where **r>0**) and the transistor which is disconnected is the pull-up transistor **MP2**.

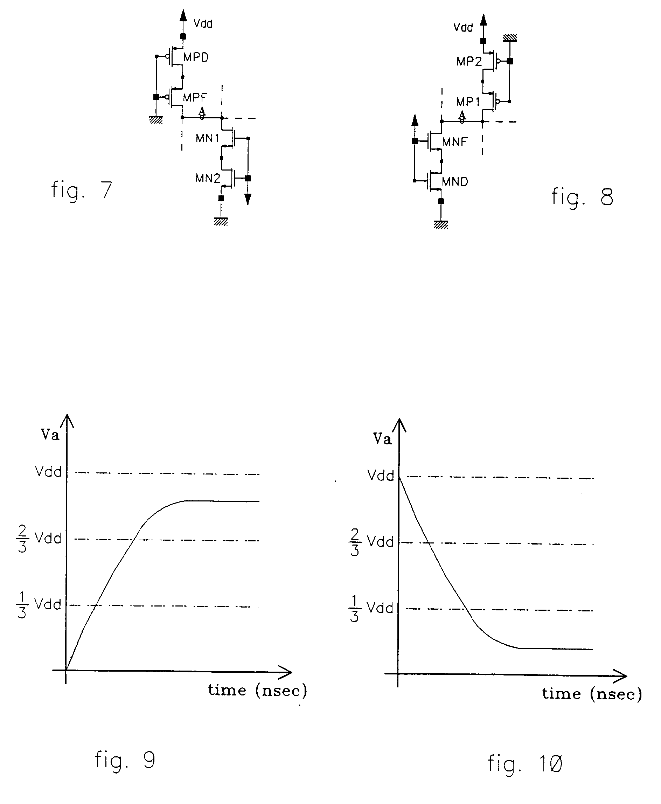

These two voltage-forcing mechanisms are put in evidence in **Figures 7** and **8**, respectively. The operating conditions as referred to said figures are the following:

$V_A$ **> Vs**     **(Fig. 7)** $V_A$ **< Vs**     **(Fig. 8)**

In modern fabrication processes, when implementing an inverter with **MOS** transistors having the minimum size as possible, a threshold voltage **Vs** comprised between **1/3 Vdd** and **2/3 Vdd** is normally obtained. Therefore, in order to be certain that the above-noted conditions be satisfied, it is necessary that $V_A$**>2/3Vdd** (**Fig. 7**) and $V_A$**<1/3Vdd** (**Fig. 8**).

On the other hand, by driving the gates of the **MPD-MPF** and **MND-MNF MOS** transistors of the input tristate gate, according to the respective configurations of **Figures 7** and **8**, with voltage step signals, the characteristic curves representing the value of $V_A$ versus time as depicted in **Figures 9** and **10** are obtained. As may be observed, the final values are reached gradually by $V_A$. Therefore, in order to have a margin of safety versus a process-spread of parameters, as well as to have a relatively short response time of the **FF**, it is advatageous that these final values be well distinct from the threshold voltage **Vs**. In order to achieve this, the **MOS**, **MN2** and **MB2** should be made sufficiently large (though without exceeding in enlarging them because then consumption would tend to increase). A good compromise which has been found is to make **MS2** about fifteen times longer than a **p**-channel **MOS** having the minumum dimensions for the fabrication process used and the **MP2** transistor about three times longer than an **n**-channel transistor having the minimum length permitted by the process (i.e. assuming that the channel width be in all cases the minimum allowed by the fabrication process and equal for both **p-MOS** and **n-MOS**).

In the circuit diagram of **Fig. 11**, such a preferred relative dimensioning is indicated by showing the relative dimensions of the **MOS** transistors in a normalized form in respect to the minimum dimensions permitted by the fabrication process which are assumed equal both for **n-MOS** and for **p-MOS**: the first number indicating the channel's width (**w**) identical for all transistors and the second number (following a dash sign) indicating the channel's length (**l**).

The remarkable difference between the lengths of **MN2** and of **MP2** is due to the fact that the mobility of vacancies is notably about half that of electrons. By considering that all the transistors must advantageously have the minimum size, with the exception of **MN2** and **MP2**, and that, any other condition being the same, an **n-MOS** transistor will "conduct" about twice a **p-MOS** transistor (because of the different mobilities of the carriers), a particularly preferred dimensioning of the two transistors may be defined as follows:

$$l_{MN2} = 15 * l_{p-MOS\ min} \text{ and } l_{MP2} = 3 * l_{n-MOS\ min}$$

More generally, for an *"ad hoc"* design, the dimensions of **MN2** and of **MP2** could vary between the following limits:

$$l_{MN2} = \text{from 0 to 30 times } l_{p-MOS\ min}$$
$$l_{MP2} = \text{from 2 to 15 times } l_{n-MOS\ min}$$

This approximate estimate has produced remarkably effective results in practical embodiments of the invention. According to such practical embodiments of the circuit of the invention, the recorded performances have been as follows:

| | |
|---|---|
| minimum supply voltage | **1.2 V** and in any case always less then the sum of the two threshold values (**IVtpI** + **Vtn**); |
| average consumption for a 23 stage counter, counting up to $2^{23}-1$, including a clock driver (**Vdd = 5.5V**) clock frequency **32768Hz** with fronts of **2μs**) | **< 0.7 μA** |
| maximum clock frequency | **> 50 MHz** |

Of course the improved circuit of the instant invention may be utilized for implementing a flip-flop of any spefically desired type based upon the **D**-type flip-flop, e.g. a **JK**, **T**, **T** with **Reset**, **T** with **Preset**, **T** with **Preset** and **Reset**, **E** (**Enable**), flip-flops and alike. Moreover, the technique of implementing synchronous combinatory networks, wherein a master and a slave latch constituting the functional structure of a flip-flop are actually "separated" and disposed one at the input and the other at the output of the combinatory network, is well known to a skilled technician. A similar structure would in any case implement a **D-FF** and also in this case the two latches which compose the functional flip-flop circuit, though separated by a number of other gates, may be realized in accordance with the present invention in order to reduce power consumption and also such an embodiment is intended to be within the spirit of the invention and the scope of the accompanying claims.

## Claims

1. A flip-flop comprising a master latch and a slave latch driven by a pair of phase-opposed clock signals, each latch comprising essentially an input tristate gate and a first and a second inverter connected into a loop and wherein said second feedback inverter of both latches is formed by four field effect complementary-by-pair transistors, functionally connected in series between the supply nodes of the circuit, characterized by the fact that

    a first pair of complementary transistors of said second four-transistor inverter of both latches have a source connected, respectively, to a supply node and a gate connected, respectively, to the other supply node;

    the other pair of complementary transistors of said four-transistor second inverter of said two latches have a drain connected to an output node of said second inverter, a gate connected to an output node of said first inverter of the respective latch and a size which is essentially smaller than the size of said first pair of complementary transistors.

2. A flip-flop as defined in claim 1, wherein said first pair of complementary transistors having a source connected to a supply node have a size which is sufficiently large for permitting to said input tristate gate to force a certain logic state on the output node of said second inverter.

3. A flip-flop as defined in claim 1, wherein said first inverter of each latch is formed by two complementary field effect transistors.

4. A flip-flop as defined in claim 1, wherein all the transistors which compose it have a minimum size as permitted by the fabrication process of the integrated device except said first pair of complementary transistors; a p-channel, pull-up, transistor of said pair has a source connected to a positive supply node and a gate connected to ground and a size which is comprised between 2 and 15 times the minimum size of an n-channel transistor of the integrated circuit and an n-channel, pull-down, transistor of said pair has a source connected to ground and a gate connected to said positive supply node and a size which is comprised between 10 and 30 times the minimum size of a p-channel transistor of the integrated circuit.

5. A flip-flop as defined in claim 1, characterized by the fact that it is a D-type flip-flop having a single preset input node in said master latch.

6. A flip-flop as defined in claim 1, characterized by the fact that it is a JK-type flip-flop having a first preset input terminal and a second reset input terminal.

7. A flip-flop as defined in claim 1, characterized by the fact that it is a T-type flip-flop without any preset and reset input terminal.

6

fig. 1

fig. 2

fig. 3

fig. 4

fig. 5

fig. 6

fig. 7

fig. 8

fig. 9

fig. 10

fig. 11

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | PATENT ABSTRACTS OF JAPAN<br>vol. 10, no. 297 (E-444)(2353) 9 October 1986<br>& JP-A-61 113 319 ( MITSUBISHI ) 31 May 1986<br>* abstract *<br>--- | 1-3,5 | H03K3/356 |
| Y | GB-A-2 174 856 (RACAL MICROELECTRONIC SYSTEMS LIMITED)<br>* page 2, line 92 - page 5, line 99; figures 2,4 * | 1-3,5 | |
| A | --- | 4,6,7 | |
| A | ELECTRONICS LETTERS<br>vol. 23, no. 23, 5 November 1987, STEVENAGE GB<br>pages 1221 - 1222<br>ORTON 'Novel CMOS latch with clock hysteresis'<br>* page 1221, right column, line 21 - page 1222, left column; figures 2,3 *<br>--- | 1-7 | |
| A | RADIO FERNSEHEN ELEKTRONIK<br>vol. 38, no. 12, 1989, BERLIN DD<br>pages 755 - 757<br>RITTER 'Statische CMOS-Schaltungstechnik'<br>* figures 11,12 *<br>----- | 1,3,5,6 | TECHNICAL FIELDS SEARCHED (Int. Cl.5 )<br><br>H03K |

The present search report has been drawn up for all claims

| Place of search | Date of completion of the search | Examiner |
|---|---|---|
| THE HAGUE | 17 DECEMBER 1992 | CANTARELLI R.J.H. |